# EUROPÄISCHE PATENTSCHRIFT

(11) **EP 2 622 314 B1**
(45) Veröffentlichungstag und Bekanntmachung des Hinweises auf die Patenterteilung: **03.09.2014**
(21) Anmeldenummer: 11736078.4
(22) Anmeldetag: 21.07.2011
(51) Int. Cl.: G01J 3/28, G01J 3/36, G01J 3/51, G01C 11/02, H04N 9/04, H04N 9/09, H01L 31/0216

(54) **DIGITALES MULTISPEKTRALES KAMERASYSTEM MIT WENIGSTENS ZWEI UNABHÄNGIGEN DIGITALEN KAMERAS**
DIGITAL MULTI-SPECTRAL CAMERA SYSTEM HAVING AT LEAST TWO INDEPENDENT DIGITAL CAMERAS
SYSTÈME DE PRISE DE VUES NUMÉRIQUE MULTISPECTRALE AYANT AU MOINS DEUX APPAREILS DE PRISE DE VUES NUMÉRIQUES INDÉPENDANTS

(30) Priorität: 28.09.2010 DE 102010041569
(43) Veröffentlichungstag der Anmeldung: 07.08.2013
(73) Patentinhaber: Leica Geosystems AG, 9435 Heerbrugg (CH)
(72) Erfinder: TIMM, Martin, 73434 Aalen (DE); WELZENBACH, Martin, 73432 Aalen (DE)
(74) Vertreter: Lorenz, Markus
(86) Internationale Anmeldenummer: PCT/EP2011/062505
(87) Internationale Veröffentlichungsnummer: WO 2012/041553

(56) Entgegenhaltungen:
- US-A- 5 900 942
- US-A1- 2007 210 244
- US-A1- 2010 232 692
- Stefan Diener ET AL: "RADIOMETRIC NORMALISATION AND COLOR COMPOSITE GENERATION OF THE DMC", ISPRS Archives - Volume XXXIII, Part B1, 1. Januar 2000 (2000-01-01), Seiten 82-88, XP55008919, Amsterdam Gefunden im Internet: URL:http://www.isprs.org/proceedings/XXXII I/congress/part1/82_XXXIII-part1.pdf [gefunden am 2011-10-07]

## Beschreibung

Die Erfindung betrifft ein digitales Kamerasystem mit wenigstens zwei unabhängigen digitalen Kameras nach der im Oberbegriff von Anspruch 1 näher definierten Art. Die Erfindung betrifft ebenfalls ein Farbfilterelement und ein Verfahren zur Bestimmung von Abweichungen der Belichtungszeiten und/oder der aufgenommenen Lichtmengen zwischen wenigstens zwei unabhängigen digitalen Kameras eines digitalen Kamerasystems sowie ein Verfahren zur Wiederherstellung einer Farbbalance für ein digitales Kamerasystem. Darüber hinaus betrifft die Erfindung auch eine Bildverarbeitungseinheit eines Kamerasystems.

In der DE 10 2005 045 036 A1 ist eine Multispektralkamera und ein Verfahren zum Erzeugen von Bildinformationen mit einer Multispektralkamera angegeben. Weiterer Stand der Technik ist aus ISPRS Archives - Vol. XXXIII, Part B1 (2000), S. 82-88 , Diener et al.: " Radiometric Normalisation and Color Composite Generation of the DMC" bekannt.

In digitalen Kamerasystemen mit mehreren unabhängigen Kameras bzw. Kameraköpfen, welche Verschlüsse und entsprechende digitale Sensoren zur Definition der aufzunehmenden Lichtmenge bzw. der Belichtungszeit aufweisen, können bei den einzelnen Kameras Abweichungen zueinander aufgrund von herstellungsbedingten Streuungen des Verschluss- und Sensorverhaltens auftreten.

In einer Multispektralkamera, bei welcher die individuellen bzw. eigenständigen oder unabhängigen Kameraköpfe jeweils Licht in unterschiedlichen Spektral- bzw. Wellenlängenbereichen, welche durch entsprechende vorgeschaltete Farbfilterelemente getrennt werden, insbesondere durch eine gleichzeitige bzw. synchrone Bildaufnahme von allen Kameraköpfen, eines Bildes derselben Szene aufnehmen, wobei die Bildsignale nachträglich zu einem multispektralen Bild zusammengefügt werden, sollte möglichst dieselbe Lichtmenge bzw. Belichtungszeit bei der Bildaufnahme für alle unabhängigen Kameraköpfe anfallen. Daher können die vorstehend erwähnten durch die leicht unterschiedlichen Belichtungszeiten der einzelnen Kameraköpfe bedingten Abweichungen bzw. Toleranzen in nachteilhafter Weise zu Farbstichen in dem multispektralen Bild führen.

Aus der Praxis bekannt ist es, mit Positionssensoren oder dergleichen Grobmessungen hinsichtlich der tatsächlichen Belichtungszeiten der einzelnen Kameraköpfe durchzuführen und daraus bereits grob eine notwendige Farbbalancierung zu berechnen. Aufgrund der unterschiedlichen Lichtmengen bzw. Bildinformationen, welche durch die unterschiedlichen Farbkanäle oder Farbfilter der einzelnen Kameras bedingt sind, können jedoch keine genaueren Schätzungen vorgenommen werden.

Der vorliegenden Erfindung liegt die Aufgabe zugrunde, ein digitales Kamerasystem der eingangs erwähnten Art hinsichtlich der Farbbalancierung der aufgenommenen Bilder weiter zu verbessern.

Diese Aufgabe wird erfindungsgemäß durch die in Anspruch 1 genannten Merkmale gelöst.

Erfindungsgemäß wird ein digitales Kamerasystem mit wenigstens zwei unabhängigen digitalen Kameras, welche Bildsignale in unterschiedlichen schmalbandigen Spektralbereichen erfassen, vorgeschlagen, wobei die wenigstens zwei unabhängigen digitalen Kameras jeweils wenigstens einen separaten flächenförmigen digitalen Bildsensor, vorzugsweise CCD-Sensor oder CMOS-Sensor und wenigstens ein in Richtung des Eintrittslichts vor dem wenigstens einen flächenförmigen digitalen Bildsensor angeordnetes bzw. dem flächenförmigen digitalen Bildsensor vorgeschaltetes, dem jeweiligen schmalbandigen Spektralbereich entsprechendes Farbfilterelement mit wenigstens einem Filterbereich aufweisen, und wobei das wenigstens eine Farbfilterelement zusätzlich wenigstens einen neutralen Bereich bzw. einen Bereich neutraler Dichte aufweist, welcher in einem Spektralbereich, der zumindest die unterschiedlichen schmalbandigen Spektralbereiche von den wenigstens zwei unabhängigen digitalen Kameras umfasst, insbesondere in einem panchromatischen Spektralbereich, lichtdurchlässig ist und welcher einem bestimmten neutralen, insbesondere ungenutzten Pixelbereich des zugehörigen, wenigstens einen flächenförmigen digitalen Bildsensors zugeordnet ist.

Der neutrale Bereich des Farbfilterelements lässt in vorteilhafter Weise in dem erforderlichen gesamten Wellenlängenspektrum Licht ohne Modifizierung passieren bzw. weist in dem erforderlichen Wellenlängenspektrum einen sehr hohen Transmissionsgrad beispielsweise von wenigstens 95 % auf. Somit erhalten die unabhängigen digitalen Kameras durch diesen neutralen Bereich dieselbe Art und Menge an Licht, da die Filtercharakteristik des neutralen Bereichs bzw. neutralen Dichtebereichs bei allen unabhängigen Kameras im Wesentlichen gleichartig ausgebildet ist. Dadurch, dass der neutrale Bereich des Farbfilterelements nun einem bestimmten neutralen, insbesondere ungenutzten Pixelbereich des zugehörigen wenigstens einen flächenförmigen digitalen Bildsensors zugeordnet bzw. über diesem angeordnet ist, fällt nun bei den unterschiedlichen unabhängigen digitalen Kameras exakt dieselbe Lichtmenge für die Bildinformation an. Falls bei einer synchronen Bildaufnahme aller unabhängigen digitalen Kameras in den neutralen bzw. ungenutzten Pixelbereichen Abweichungen auftreten, sind diese nicht durch die unterschiedlichen Farbkanäle, sondern durch unterschiedliche Verschlusszeiten oder sonstige, insbesondere mechanische Toleranzen bedingt. Sonach kann eine entsprechende Ausgleichsrechnung während der Bildverarbeitung durchgeführt werden, wobei zu starke Farbanteile entsprechend gedämpft werden bzw. eine Normierung oder dergleichen erfolgt.

Besonders vorteilhaft ist es, wenn der flächenförmige digitale Bildsensor einen ohnehin von der Anwendung ungenutzten Pixelbereich aufweist, der als neutraler Bereich verwendet werden kann. Der neutrale Pixelbereich sollte dabei ausreichend groß sein (z. B. 2.000 Pixel oder dergleichen), da zwischen den unterschiedlichen Bereichen des Farbfilterelements auch ein Übergangsbereich entsprechender Größe (zwischen den unterschiedlichen Glassorten) vorgesehen sein sollte.

Die wenigstens zwei unabhängigen digitalen Kameras können jeweils einen separaten Verschluss und/oder ein separates Objektiv aufweisen. Bei einer derartigen Anordnung sind die erfindungsgemäßen Maßnahmen besonders vorteilhaft, da es zu stärkeren Abweichungen der Belichtungszeiten und/oder der aufgenommenen Lichtmengen zwischen den wenigstens zwei unabhängigen digitalen Kameras kommen kann.

Die wenigstens zwei unabhängigen digitalen Kameras können derart zueinander angeordnet sein, dass wenigstens annähernd dieselbe Szene in den unterschiedlichen schmalbandigen Spektralbereichen der wenigstens zwei unabhängigen digitalen Kameras aufnehmbar und aus den Bildsignalen der unterschiedlichen Farbkanäle oder schmalbandigen Spektralbereiche ein multispektrales Bild der Szene bzw. der erfassten Bildersignale kombinierbar ist.

Die wenigstens zwei unabhängigen digitalen Kameras können abgesehen von ihren jeweiligen den unterschiedlichen Farbempfindlichkeiten oder schmalbandigen Spektralbereichen entsprechenden Farbfilterelementen im Wesentlichen gleichartige Aufnahmeeigenschaften aufweisen und/oder im Wesentlichen baugleich sein, wobei deren flächenförmige digitale Bildsensoren, deren gegebenenfalls vorhandenen separaten Verschlüsse und/oder Objektive im Wesentlichen gleichartig ausgeführt sind.

Vorteilhaft ist es, wenn das wenigstens eine Farbfilterelement zwei streifenförmige neutrale Bereiche an gegenüberliegenden Seiten des Filterbereichs aufweist. Die Nutzung mehrerer verschiedener neutraler Filterbereiche ermöglicht einen verbesserten bzw. genaueren Ausgleich der optischen Abweichungen.

Das digitale Kamerasystem kann als multispektrales Kamerasystem mit vier unabhängigen digitalen Kameras ausgebildet sein, welches
- eine erste unabhängige digitale Kamera mit einem ersten Farbfilterelement, welches in einem Spektralbereich mit Wellenlängen von etwa 600 nm bis etwa 700 nm bzw. für rotes Licht lichtdurchlässig ist,
- eine zweite unabhängige digitale Kamera mit einem zweiten Farbfilterelement, welches in einem Spektralbereich mit Wellenlängen von etwa 500 nm bis etwa 600 nm bzw. für grünes Licht lichtdurchlässig ist,
- eine dritte unabhängige digitale Kamera mit einem dritten Farbfilterelement, welches in einem Spektralbereich mit Wellenlängen von etwa 400 nm bis etwa 500 nm bzw. für blaues Licht lichtdurchlässig ist, und
- eine vierte unabhängige digitale Kamera mit einem vierten Farbfilterelement, welches in einem Spektralbereich mit Wellenlängen von etwa 700 nm bis etwa 900 nm bzw. für nahes Infrarotlicht lichtdurchlässig ist, umfasst.

Das erste, das zweite, das dritte und das vierte Farbfilterelement kann jeweils einen neutralen Bereich aufweisen, welcher in einem Spektralbereich von etwa 400 nm bis etwa 900 nm lichtdurchlässig ist. Dadurch wird der gesamte Spektralbereich der Farbfilterelemente durch die neutralen Bereiche der Farbfilterelemente abgedeckt.

Das digitale Kamerasystem kann als multispektrales digitales Kamerasystem für die Fotogrammetrie zur Aufnahme von Luftbildern aus Flugzeugen eingesetzt werden.

In Anspruch 9 ist ein Farbfilterelement für wenigstens einen flächenförmigen digitalen Bildsensor angegeben.

In Anspruch 10 ist ein Verfahren zur Bestimmung von Abweichungen der Belichtungszeiten und/oder der aufgenommenen Lichtmengen zwischen wenigstens zwei unabhängigen digitalen Kameras eines digitalen Kamerasystems, insbesondere bei einer synchronen Bildaufnahme der wenigstens zwei unabhängigen Kameras, vorzugsweise derselben Szene, angegeben, wobei nach erfolgter synchroner Bildaufnahme, die in den jeweiligen neutralen Pixelbereichen der flächenförmigen digitalen Bildsensoren der wenigstens zwei unabhängigen digitalen Kameras aufgenommenen Lichtmengen miteinander verglichen werden.

In Anspruch 11 wird ein Verfahren zur Einstellung einer Farbbalance für ein digitales Kamerasystem vorgeschlagen, wobei die Abweichungen der Belichtungszeiten und/oder der aufgenommenen Lichtmengen zwischen den wenigstens zwei unabhängigen digitalen Kameras des digitalen Kamerasystems bestimmt werden, wonach bei der Verarbeitung eines von den wenigstens zwei unabhängigen digitalen Kamerasystems in den jeweiligen unterschiedlichen schmalbandigen Spektralbereichen bzw. Farbkanälen synchron aufgenommenen Bilds derselben Szene eine Ausgleichsrechnung derart erfolgt, dass die jeweiligen schmalbandigen Spektralbereiche entsprechend der zuvor bestimmten Abweichungen jeweils unverändert gelassen, gedämpft oder verstärkt, d. h. nominiert werden.

Des Weiteren ist in Anspruch 12 eine Bildverarbeitungseinheit eines digitalen Kamerasystems angegeben.

Vorteilhafte Ausgestaltungen und Weiterbildungen der Erfindung ergeben sich aus den Unteransprüchen. Nachfolgend ist anhand der Zeichnung prinzipmäßig ein Ausführungsbeispiel der Erfindung angegeben.

Es zeigen:
- Fig. 1: eine schematische Darstellung eines erfindungsgemäβen multispektralen Kamerasystems mit vier unabhängigen digitalen Kameras;
- Fig. 2: eine schematische Darstellung einer unabhängigen digitalen Kamera des erfindungsgemäßen multispektralen digitalen Kamerasystems aus Fig. 1;
- Fig. 3: eine schematische Darstellung eines Farbfilterelements; und
- Fig. 4: eine schematische Darstellung einer Anordnung von vier Farbfilterelementen in dem erfindungsgemäßen multispektralen digitalen Kamerasystem.

Das erfindungsgemäße digitale, insbesondere multispektrale Kamerasystem wird nachfolgend als fotogrammetrisches Luftbildaufnahmegerät zur Aufnahme von Luftbildern aus Flugzeugen (nicht gezeigt) eingesetzt. In weiteren, nicht dargestellten Ausführungsbeispielen kann das erfindungsgemäße digitale Kamerasystem auch beispielsweise in einem Mikroskop oder dergleichen Verwendung finden.

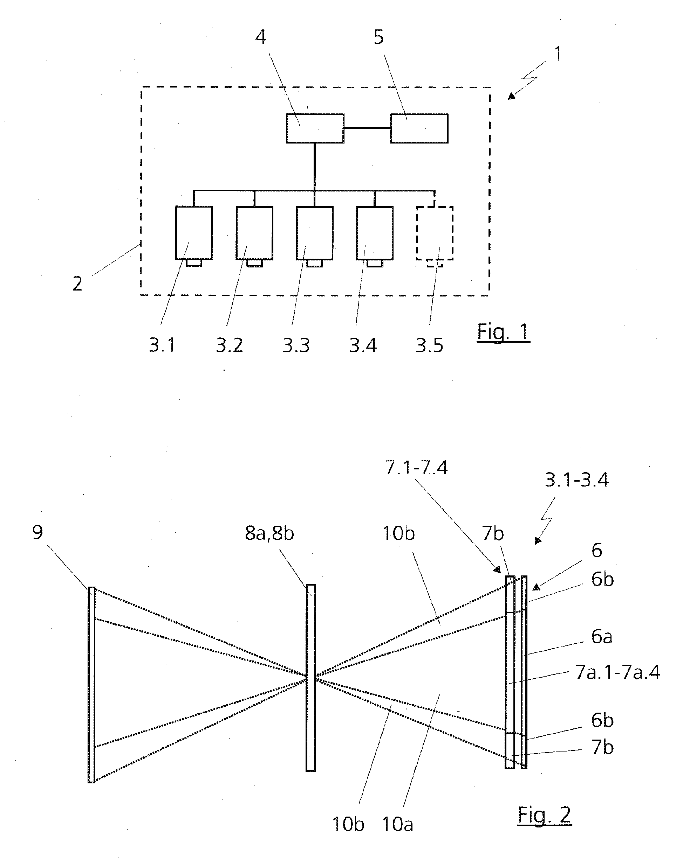

Figur 1 zeigt ein fotogrammetrisches Luftbildaufnahmegerät 1 mit einem erfindungsgemäßen multispektralen digitalen Kamerasystem 2 mit vier unabhängigen digitalen Kameras 3.1 bis 3.4, welche Bildsignale in unterschiedlichen schmalbandigen Spektralbereichen erfassen und an eine Bildverarbeitungseinheit 4 weiterleiten. Die Bildverarbeitungseinheit 4 übermittelt anschließend die Signale an eine Bildspeichereinheit 5. Zusätzlich kann das erfindungsgemäße digitale Kamerasystem 2 eine hochauflösende panchromatische unabhängige Digitalkamera 3.5 aufweisen (gestrichelt angedeutet), wobei die unabhängigen digitalen Kameras 3.1 bis 3.4 niedrig auflösend ausgeführt sind.

Die Anordnung der unabhängigen digitalen Kameras 3.1 bis 3.5 in dem erfindungsgemäßen digitalen Kamerasystem 2 ist in Fig. 1 stark vereinfacht dargestellt und unterscheidet sich von der tatsächlichen Anordnung der unabhängigen digitalen Kameras 3.1 bis 3.5 wesentlich.

Die vier unabhängigen digitalen Kameras 3.1 bis 3.4 sind derart zueinander angeordnet, dass wenigstens annähernd dieselbe Szene in deren unterschiedlichen schmalbandigen Spektralbereichen aufnehmbar und aus den Bildsignalen der unterschiedlichen schmalbandigen Spektralbereiche ein multispektrales Bild der Szene, insbesondere in der Bildverarbeitungseinheit 4 kombinierbar ist. Bei der Kombination kann optional auch die unabhängige digitale panchromatische Kamera 3.5 eingesetzt werden.

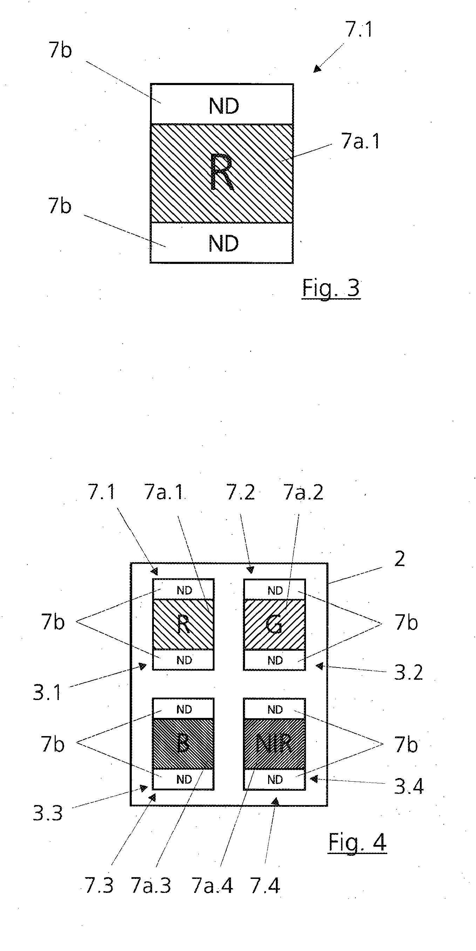

In Figur 2 ist eine einzelne unabhängige digitale Kamera 3.1 bis 3.4 des erfindungsgemäßen digitalen Kamerasystems 2 dargestellt. Dabei weist die unabhängige digitale Kamera 3.1 bis 3.4 jeweils einen separaten flächenförmigen, als CCD-Sensor ausgebildeten digitalen Bildsensor 6 und ein, dem flächenförmigen digitalen Bildsensor 6 vorgeschaltetes, Farbfilterelement 7.1 bis 7.4 mit einem Filterbereich 7a.1 bis 7a.4 für den jeweiligen schmalbandigen Spektralbereich auf (siehe auch Figuren 3 und 4). In weiteren Ausführungsbeispielen kann der digitale Bildsensor 6 auch für den jeweiligen schmalbandigen Spektralbereich als CMOS-Sensor ausgebildet sein.

Das Farbfilterelement 7.1 bis 7.4 weist zwei neutrale Bereiche 7b auf, welche in einem Spektralbereich ND, der zumindest die unterschiedlichen schmalbandigen Spektralbereiche der vier unabhängigen digitalen Kameras 3.1 bis 3.4 umfasst, insbesondere in einem panchromatischen Spektralbereich lichtdurchlässig ist. Die neutralen Bereiche 7b bzw. die Bereiche neutraler Dichte des Farbfilterelements 7.1 bis 7.4 sind zwei bestimmten neutralen, insbesondere ungenutzten Pixelbereichen 6b des zugehörigen flächenförmigen digitalen Bildsensors 6 zugeordnet. Der für die Aufnahme der Bildsignale der Szene für das multispektrale Bild genutzte Bereich des flächenförmigen digitalen Bildsensors 6 ist mit dem Bezugszeichen 6a versehen.

Die unabhängige digitale Kamera 3.1 bis 3.4 weist einen separaten Verschluss 8a und ein separates Objektiv 8b, d. h. eine separate Optik auf. Die aufzunehmende Szene 9 ist in Figur 2 vereinfacht dargestellt. Wie weiter aus Figur 2 ersichtlich, nimmt der digitale Bildsensor 6 die Szene 9 auf. Dabei wird der genutzte Pixelbereich 6a mit Licht 10a belichtet, welches durch den Filterbereich 7a.1 bis 7a.4 des Farbfilterelements 7.1 bis 7.4 tritt. Der Filterbereich 7a.1 bis 7a.4 ist derart ausgebildet, dass lediglich Licht der entsprechenden Wellenlänge hindurchtritt. Die ungenutzten Pixelbereiche 6b des digitalen flächenförmigen Bildsensors 6 werden mit Licht 10b belichtet, welches durch die, den ungenutzten Pixelbereichen 6b zugeordneten, neutralen Bereiche 7b des Farbfilterelements 7 tritt.

Die vier unabhängigen digitalen Kameras 3.1 bis 3.4 weisen, abgesehen von ihren jeweiligen, den unterschiedlichen schmalbandigen Spektralbereichen entsprechenden, Farbfilterelementen 7.1 bis 7.4 im Wesentlichen gleichartige Aufnahmeeigenschaften auf und/oder sind im Wesentlichen baugleich, wobei deren flächenförmige digitale Bildsensoren 6, deren separate Verschlüsse 8a und deren Objektive 8b im Wesentlichen gleichartig ausgeführt sind.

In Figur 3 ist ein Farbfilterelement 7.1 mit einem Filterbereich 7a.1 dargestellt, welcher lichtdurchlässig in einem roten schmalbandigen Spektralbereich R mit Wellenlängen von etwa 600 nm bis etwa 700 nm ist. In Figur 3 handelt es sich um eine Draufsicht auf das Farbfilterelement 7.1, während in Figur 2 eine seitliche Ansicht eines derartigen Farbfilterelements 7.1 gezeigt ist. Das Farbfilterelement 7.1 weist zwei streifenförmige neutrale Bereiche 7b an gegenüberliegenden Seiten des Filterbereichs 7a.1 auf. Das Farbfilterelement 7.1 kann auch als Streifenfilter bezeichnet werden.

Das Farbfilterelement 7.1 für den flächenförmigen digitalen Bildsensor 6 weist den Filterbereich 7a.1 für den durchzulassenden ersten Spektralbereich R des Lichts und den neutralen Bereich 7b für den zweiten Spektralbereich ND auf, wobei der zweite Spektralbereich ND des neutralen Bereichs 7b breiter ist als der erste schmalbandige Spektralbereich R des Filterbereichs 7a.1 und diesen umfasst.

Figur 4 zeigt eine Vorderansicht des erfindungsgemäßen digitalen Kamerasystems 2 mit entsprechend nebeneinander angeordneten unabhängigen digitalen Kameras 3.1 bis 3.4, von denen in Figur 4 lediglich deren jeweilige Farbfilterelemente 7.1 bis 7.4 gezeigt sind. Die zugehörigen flächenförmigen digitalen Bildsensoren 6 sind unterhalb dem der Farbfilterelemente 7.1 bis 7.4 angeordnet. Die separaten Verschlüsse 8a und Objektive 8b der Kameras 3.1 bis 3.4 sind ebenfalls in Figur 4 nicht gezeigt. Die erste unabhängige digitale Kamera 3.1 ist mit einem ersten Farbfilterelement 7.1 versehen, welches im Wesentlichen nur in dem Spektralbereich R mit Wellenlängen von etwa 600 nm bis etwa 700 nm lichtdurchlässig ist. Die zweite unabhängige digitale Kamera 3.2 ist mit dem zweiten Farbfilterelement 7.2 versehen, welches im Wesentlichen nur in einem Spektralbereich G für grünes Licht mit Wellenlängen von etwa 500 nm bis etwa 600 nm lichtdurchlässig ist. Die dritte unabhängige digitale Kamera 3.3 ist mit dem dritten Farbfilterelement 7.3 versehen, welches im Wesentlichen nur in einem Spektralbereich B für blaues Licht mit Wellenlängen von etwa 400 nm bis etwa 500 nm lichtdurchlässig ist. Die vierte unabhängige digitale Kamera 3.4 ist mit einem vierten Farbfilterelement 7.4 versehen, welches im Wesentlichen nur in einem Spektralbereich NIR für nahes Infrarotlicht mit Wellenlängen von etwa 700 nm bis etwa 900 nm lichtdurchlässig ist. Das erste, das zweite, das dritte und das vierte Farbfilterelement 7.1 bis 7.4 weist jeweils einen neutralen Bereich 7b auf, welcher in einem Spektralbereich ND von etwa 400 nm bis 900 nm lichtdurchlässig ist. Des Weiteren weisen die Farbfilterelemente 7.1 bis 7.4 entsprechende Filterbereiche 7a.1 bis 7a.4 für die jeweiligen Spektralbereiche R, G, B, NIR auf. Die genannten Spektralbereiche R, G, B, NIR sind rein beispielhaft. In weiteren, nicht dargestellten Ausführungsbeispielen kommen beliebige Anwendungen mit entsprechend anderen Spektralbereichen in Betracht.

Die Bildverarbeitungseinheit 4 des digitalen Kamerasystems 2 ist zur Durchführung eines Verfahrens zur Bestimmung von Abweichungen der Belichtungszeiten und/oder der aufgenommenen Lichtmengen zwischen den unabhängigen digitalen Kameras 3.1 bis 3.4 des digitalen Kamerasystems 2 eingerichtet, wobei insbesondere bei einer synchronen Bildaufnahme der unabhängigen digitalen Kameras 3.1 bis 3.4 vorzugsweise derselben Szene 9 nach erfolgter synchroner Bildaufnahme die in den jeweiligen neutralen Pixelbereichen 6b der flächenförmigen digitalen Bildsensoren 6 der unabhängigen digitalen Kameras 3.1 bis 3.4 aufgenommenen Lichtmengen miteinander verglichen werden.

Des Weiteren ist die Bildverarbeitungseinheit 4 des digitalen Kamerasystems 2 eingerichtet zur Durchführung eines Verfahrens zur Einstellung einer Farbbalance für das digitale Kamerasystem 2, wobei die Abweichungen der Belichtungszeiten und/oder der aufgenommenen Lichtmengen zwischen den vier unabhängigen digitalen Kameras 3.1 bis 3.4 des digitalen Kamerasystems 2 mittels des vorstehend erwähnten Verfahrens bestimmt werden, wonach bei der Verarbeitung eines, von den vier unabhängigen digitalen Kameras 3.1 bis 3.4 in den jeweiligen unterschiedlichen schmalbandigen Spektralbereichen R, G, B, NIR synchron aufgenommenen, Bildes derselben Szene 9 eine Ausgleichsrechnung derart erfolgt, dass die Bildsignale der jeweiligen schmalbandigen Spektralbereiche R, G, B, NIR entsprechend der zuvor bestimmten Abweichungen jeweils unverändert gelassen, gedämpft oder verstärkt werden und sonach eine entsprechende Normierung der Farbkanäle R, G, B, NIR erfolgt.

## Patentansprüche

1. Digitales Kamerasystem (2) mit einer Bildverarbeitungseinheit (4) und mit wenigstens zwei unabhängigen digitalen Kameras (3.1-3.4), welche Bildsignale in unterschiedlichen schmalbandigen Spektralbereichen erfassen, welche jeweils einen separaten Verschluss (8a) und/oder ein separates Objektiv (8b) aufweisen und welche jeweils wenigstens einen separaten flächenförmigen digitalen Bildsensor (6) und wenigstens ein dem wenigstens einen flächenförmigen digitalen Bildsensor (6) vorgeschaltetes dem jeweiligen schmalbandigen Spektralbereich entsprechendes Farbfilterelement (7.1-7.4) mit wenigstens einem Filterbereich (7a.1-7a.4) aufweisen, welches zusätzlich wenigstens einen neutralen Bereich (7b) aufweist, welcher in einem Spektralbereich (ND), der zumindest die unterschiedlichen schmalbandigen Spektralbereiche von den wenigstens zwei unabhängigen digitalen Kameras (3.1-3.4) umfasst, lichtdurchlässig ist und welcher über wenigstens einem bestimmten neutralen Pixelbereich (6b) des zugehörigen wenigstens einen flächenförmigen digitalen Bildsensors (6) angeordnet ist, wobei die Bildverarbeitungseinheit (4) zur Durchführung eines Verfahrens zur Einstellung einer Farbbalance für das digitale Kamerasystem (2) eingerichtet ist, wobei Abweichungen der Belichtungszeiten und/oder der aufgenommenen Lichtmengen zwischen den wenigstens zwei unabhängigen digitalen Kameras (3.1-3.4) des digitalen Kamerasystems (2) bei einer synchronen Bildaufnahme der wenigstens zwei unabhängigen Kameras (3.1-3.4) derselben Szene (9) bestimmt werden, wobei nach erfolgter synchroner Bildaufnahme die in den jeweiligen neutralen Pixelbereichen (6b) der flächenförmigen digitalen Bildsensoren (6) der wenigstens zwei unabhängigen digitalen Kameras (3.1-3.4) aufgenommenen Lichtmengen miteinander verglichen werden, wonach bei der Verarbeitung eines von den wenigstens zwei unabhängigen digitalen Kameras (3.1-3.4) in den jeweiligen unterschiedlichen schmalbandigen Spektralbereichen (R,G,B,NIR) synchron aufgenommenen Bilds derselben Szene (9) eine Ausgleichsrechnung derart erfolgt, dass die Bildsignale der jeweiligen schmalbandigen Spektralbereiche (R,G,B,NIR) entsprechend der zuvor bestimmten Abweichungen jeweils unverändert gelassen, gedämpft oder verstärkt werden.

2. Digitales Kamerasystem nach Anspruch 1,
**dadurch gekennzeichnet, dass** die wenigstens zwei unabhängigen digitalen Kameras (3.1-3.4) derart zueinander angeordnet sind, dass wenigstens annähernd dieselbe Szene (9) in den unterschiedlichen schmalbandigen Spektralbereichen (R,G,B,NIR) der wenigstens zwei unabhängigen digitalen Kameras (3.1-3.4) aufnehmbar und aus den Bildsignalen der unterschiedlichen schmalbandigen Spektralbereiche (R,G,B,NIR) ein multispektrales Bild der Szene (9) kombinierbar ist.

3. Digitales Kamerasystem nach Anspruch 1 oder 2,
**dadurch gekennzeichnet , dass** die wenigstens zwei unabhängigen digitalen Kameras (3.1-3.4), abgesehen von ihren jeweiligen den unterschiedlichen schmalbandigen Spektralbereichen (R,G,B,NIR) entsprechenden Farbfilterelementen (7.1-7.4) im Wesentlichen gleichartige Aufnahmeeigenschaften aufweisen und/oder im Wesentlichen baugleich sind, wobei deren flächenförmige digitale Bildsensoren (6), deren gegebenenfalls vorhandene separate Verschlüsse (8a) und Objektive (8b), im Wesentlichen gleichartig ausgeführt sind.

4. Digitales Kamerasystem nach Anspruch 1, 2 oder 3,
**dadurch gekennzeichnet, dass** das wenigstens eine Farbfilterelement (7.1-7.4) zwei streifenförmige neutrale Bereiche (7b) an gegenüberliegenden Seiten des Filterbereichs (7a.1-7a.4) aufweist.

5. Digitales Kamerasystem nach einem der Ansprüche 1 bis 4, **gekennzeichnet durch:**
- eine erste unabhängige digitale Kamera (3.1) mit einem ersten Farbfilterelement (7.1), welches in einem Spektralbereich (R) mit Wellenlängen von etwa 600 nm bis etwa 700 nm lichtdurchlässig ist,
- eine zweite unabhängige digitale Kamera (3.2) mit einem zweiten Farbfilterelement (7.2), welches in einem Spektralbereich (G) mit Wellenlängen von etwa 500 nm bis etwa 600 nm lichtdurchlässig ist,
- eine dritte unabhängige digitale Kamera (3.3) mit einem dritten Farbfilterelement (7.3), welches in einem Spektralbereich (B) mit Wellenlängen von etwa 400 nm bis etwa 500 nm lichtdurchlässig ist, und
- eine vierte unabhängige digitale Kamera (3.4) mit einem vierten Farbfilterelement (7.4), welches in einem Spektralbereich (NIR) mit Wellenlängen von etwa 700 nm bis etwa 900 nm lichtdurchlässig ist.

6. Digitales Kamerasystem nach Anspruch 5,
**dadurch gekennzeichnet, dass** das erste, das zweite, das dritte und das vierte Farbfilterelement (7.1-7.4) jeweils einen neutralen Bereich (7b) aufweisen, welcher in einem Spektralbereich (ND) von etwa 400 nm bis etwa 900 nm lichtdurchlässig ist.

7. Digitales Kamerasystem nach einem der Ansprüche 1 bis 6 für die Photogrammetrie zur Aufnahme von Luftbildern aus Flugzeugen.

8. Verfahren zur Einstellung einer Farbbalance für ein digitales Kamerasystem (2) nach einem der Ansprüche 1 bis 7, wobei Abweichungen der Belichtungszeiten und/oder der aufgenommenen Lichtmengen zwischen den wenigstens zwei unabhängigen digitalen Kameras (3.1-3.4) des digitalen Kamerasystems (2) bei einer synchronen Bildaufnahme der wenigstens zwei unabhängigen Kameras (3.1-3.4) derselben Szene (9) bestimmt werden, wobei nach erfolgter synchroner Bildaufnahme die in den jeweiligen neutralen Pixelbereichen (6b) der flächenförmigen digitalen Bildsensoren (6) der wenigstens zwei unabhängigen digitalen Kameras (3.1-3.4) aufgenommenen Lichtmengen miteinander verglichen werden, wonach bei der Verarbeitung eines von den wenigstens zwei unabhängigen digitalen Kameras (3.1-3.4) in den jeweiligen unterschiedlichen schmalbandigen Spektralbereichen (R,G,B,NIR) synchron aufgenommenen Bilds derselben Szene (9) eine Ausgleichsrechnung derart erfolgt, dass die Bildsignale der jeweiligen schmalbandigen Spektralbereiche (R,G,B,NIR) entsprechend der zuvor bestimmten Abweichungen jeweils unverändert gelassen, gedämpft oder verstärkt werden.

9. Bildverarbeitungseinheit (4) eines digitalen Kamerasystems (2) eingerichtet zur Durchführung eines Verfahrens nach Anspruch 8.

## Claims

1. Digital camera system (2) with an image-processing unit (4) and with at least two independent digital cameras (3.1 - 3.4) which capture image signals in different narrowband spectral regions, which each have a separate shutter (8a) and/or a separate objective (8b), and which each have at least one separate sheet-like digital image sensor (6) and at least one colour-filter element (7.1 - 7.4) arranged upstream of the at least one sheet-like digital image sensor (6) and corresponding to the respective narrowband spectral region and with at least one filtering region (7a.1 - 7a.4), which additionally has at least one neutral region (7b) which is light-transmitting in a spectral region (ND) that includes at least the different narrowband spectral regions of the at least two independent digital cameras (3.1 - 3.4), and which has been arranged above at least one particular neutral pixel region (6b) of the associated at least one sheet-like digital image sensor (6), wherein the image-processing unit (4) has been set up for implementing a method for setting a colour balance for the digital camera system (2), wherein deviations in the exposure-times and/or in the recorded quantities of light between the at least two independent digital cameras (3.1 - 3.4) of the digital camera system (2) are determined in the course of a synchronous recording of an image of the same scene (9) by the at least two independent cameras (3.1 - 3.4), wherein after synchronous recording of an image has taken place the quantities of light recorded in the respective neutral pixel regions (6b) of the sheet-like digital image sensors (6) of the at least two independent digital cameras (3.1 - 3.4) are compared with one another, whereupon in the course of the processing of an image of the same scene (9) recorded synchronously in the respective different narrowband spectral regions (R, G, B, NIR) by the at least two independent digital cameras (3.1 - 3.4) a compensating calculation is performed in such a manner that the image signals of the respective narrowband spectral regions (R, G, B, NIR) are respectively left unchanged, attenuated or amplified, in accordance with the previously determined deviations.

2. Digital camera system according to Claim 1,
**characterized in that** the at least two independent digital cameras (3.1 - 3.4) have been arranged with respect to one another in such a manner that at least approximately the same scene (9) can be recorded in the different narrowband spectral regions (R, G, B, NIR) of the at least two independent digital cameras (3.1 - 3.4), and a multispectral image of the scene (9) can be combined from the image signals of the different narrowband spectral regions (R, G, B, NIR).

3. Digital camera system according to Claim 1 or 2,
**characterised in that** the at least two independent digital cameras (3.1 - 3.4) have substantially similar recording properties, apart from their respective colour-filter elements (7.1 - 7.4) corresponding to the different narrowband spectral regions (R, G, B, NIR), and/or have substantially identical structure, whereby the sheet-like digital image sensors (6) thereof and the optionally present separate shutters (8a) and objectives (8b) thereof have substantially been realised in similar manner.

4. Digital camera system according to Claim 1, 2 or 3,
**characterised in that** the at least one colour-filter element (7.1 - 7.4) has two strip-shaped neutral regions (7b) on opposite sides of the filtering region (7a.1 - 7a.4).

5. Digital camera system according to one of Claims 1 to 4, **characterised by**:
- a first independent digital camera (3.1) with a first colour-filter element (7.1) which is light-transmitting in a spectral region (R) with wavelengths from about 600 nm to about 700 nm,
- a second independent digital camera (3.2) with a second colour-filter element (7.2) which is light-transmitting in a spectral region (G) with wavelengths from about 500 nm to about 600 nm,
- a third independent digital camera (3.3) with a third colour-filter element (7.3) which is light-transmitting in a spectral region (B) with wavelengths from about 400 nm to about 500 nm, and
- a fourth independent digital camera (3.4) with a fourth colour-filter element (7.4) which is light-transmitting in a spectral region (NIR) with wavelengths from about 700 nm to about 900 nm.

6. Digital camera system according to Claim 5,
**characterized in that** the first, the second, the third and the fourth colour-filter element (7.1 - 7.4) each have a neutral region (7b) which is light-transmitting in a spectral region (ND) from about 400 nm to about 900 nm.

7. Digital camera system according to one of Claims 1 to 6 for photogrammetry for the purpose of recording aerial photographs from aircraft.

8. Method for setting a color balance for a digital camera system (2) according to one of Claims 1 to 7, wherein deviations in the exposure-times and/or in the recorded quantifies of light between the at least two independent digital cameras (3.1 - 3.4) of the digital camera system (2) are determined in the course of a synchronous recording of an image of the same scene (9) by the at least two independent cameras (3.1 - 3.4), wherein after synchronous recording of an image has taken place the quantities of light recorded in the respective neutral pixel regions (6b) of the sheet-like digital image sensors (6) of the at least two independent digital cameras (3.1 - 3.4) are compared with one another, whereupon in the course of the processing of an image of the same scene (9) recorded synchronously in the respective different narrowband spectral regions (R, G, B, NIR) by the at least two independent digital cameras (3.1 - 3.4) a compensating calculation is performed in such a manner that the image signals of the respective narrowband spectral regions (R, G, B, NIR) are respectively left unchanged, attenuated or amplified, in accordance with the previously determined deviations.

9. Image-processing unit (4) of a digital camera system (2), set up for implementing a method according to Claim 8.

## Revendications

1. Système à caméra numérique (2) comportant une unité de traitement de l'image (4) ainsi qu'au moins deux caméras numériques indépendantes (3.1 - 3.4), qui captent des signaux d'images à bandes courtes dans différents domaines spectraux, qui sont respectivement équipés d'un diaphragme (8a) et/ou d'un objectif (8b) distincts et qui comportent respectivement au moins un capteur d'image numérique distinct de forme plane (6) et au moins un filtre de couleurs (7.1 - 7.4) pré-connecté audit au moins un capteur d'image numérique de forme plane (6), ayant au moins un domaine filtrant (7a.1 - 7a.4) qui présente en outre au moins un secteur neutre (7b), qui laisse passer la lumière dans un domaine spectral (ND) qui englobe au moins différents domaines spectraux à bandes courtes desdites au moins deux caméras numériques indépendantes (3.1 - 3.4), et qui est adapté sur au moins un domaine neutre déterminé de pixels (6b) dudit au moins un capteur d'image numérique de forme plane (6) correspondant, dans lequel l'unité de traitement de l'image (4) est agencée pour exécuter un procédé de réglage d'une balance de couleurs pour le système de caméra numérique (2), dans lequel on détermine des écarts des temps d'exposition et/ou des quantités de lumière des prises par lesdites au moins deux caméras numériques indépendantes (3.1 - 3.4) du système de caméra numérique (2), lors d'une prise de vue d'une même scène par lesdites au moins deux caméras numériques indépendantes (3.1 - 3.4), dans lequel, après une prise de vue synchrone réussie, les quantités de lumière sont comparées entre elles, dans les domaines neutres de pixels (6b) correspondants du capteur d'image numérique de forme plane (6) desdites au moins deux caméras numériques indépendantes (3.1 -3.4), après quoi, lors du traitement d'une image synchronisée saisie de la même scène (9), par lesdites au moins deux caméras numériques indépendantes (3.1 - 3.4) dans les domaines spectraux différents respectifs à bande étroite (R, G, B, NIR), on effectue un calcul de compensation de telle manière que les signaux d'images dans les domaines spectraux différents respectifs à bande étroite (R, G, B, NIR), sont soit gardés inchangés, soit sont amortis, soit sont renforcés en fonction des écarts détectés précédemment.

2. Système à caméra numérique selon la revendication 1,
**caractérisé en c e que**, lesdites au moins deux caméras numériques indépendantes (3.1 - 3.4), sont agencées de telle marnière que la même scène (9) peut au moins approximativement être captée dans les domaines spectraux différents respectifs à bande étroite (R, G, B, NIR) desdites au moins deux caméras numériques indépendantes (3.1 - 3.4) et en ce qu'une image multispectrale de la scène (9) peut être combinée à partir des signaux d'images dans les domaines spectraux différents respectifs à bande étroite (R, G, B, NIR).

3. Système à caméra numérique selon les revendications 1 ou 2,
**caractérisé en ce que,** lesdites au moins deux caméras numériques indépendantes (3.1 - 3.4) ont des caractéristiques de prises de vues similaires, à l'exception des éléments de filtres de couleurs respectifs (7.1 - 7.4), correspondant aux domaines spectraux différents respectifs à bande étroite (R, G, B, NIR) et /ou sont sensiblement de même constriction, dans lequel leur capteur d'image numérique de forme plane (6), leur obturateur éventuellement disponible séparé (8a) et leur objectif (8b) sont fabriqués de façon identique.

4. Système à caméra numérique selon les revendications 1, 2 ou 3,
**caractérisé en ce que,** au moins un élément de filtre de couleur (7.1 - 7.4) comporte deux secteurs neutres en forme de bande (7b) disposées de deux côtés opposés du domaine de filtrage (7a.1 - 7a.4).

5. Système à caméra numérique selon l'une des revendications 1 à 4,
**caractérisé par,**
- une première caméra numérique indépendante (3.1) comportant un premier élément de filtre (7.1) qui laisse passer la lumière dans un domaine spectral (R) de longueurs d'ondes entre environ 600 nm et environ 700 nm,
- une deuxième caméra numérique indépendante (3.2) comportant un deuxième élément de filtre (7.2) qui laisse passer la lumière dans un domaine spectral (G) de longueurs d'ondes entre environ 500 nm et environ 600 nm,
- une troisième caméra numérique indépendante (3.3) comportant un troisième élément de filtre (7.3) qui laisse passer la lumière dans un domaine spectral (B) de longueurs d'ondes entre environ 400 nm et environ 500 nm, et
- une quatrième caméra numérique indépendante (3.4) comportant un quatrième élément de filtre (7.4) qui laisse passer la lumière dans un domine spectral (NIR) de longueurs d'ondes entre environ 700 nm et environ 900 nm.

6. Système à caméra numérique selon la revendication 5,
**caractérisé en ce que,** le premier, le deuxième, le troisième et le quatrième élément de filtre (7.1 - 7.4) comportent respectivement un secteur neutre (7b) qui laisse passer la lumière dans un domaine spectral (ND) sensiblement compris entre 400 nm et 900 nm.

7. Système à caméra numérique selon l'une des revendications 1 à 6, pour la photogrammétrie destinée à la prise de vues aérienne depuis des avions.

8. Procédé de réglage d'une balance de couleurs pour un système à caméra numérique (2) selon l'une des revendications 1 à 7, dans lequel on détermine des écarts de temps d'exposition et/ou des quantités de lumière entre lesdites au moins deux caméras numériques indépendantes (3.1 - 3.4) du système de caméra numérique (2), lors d'une prise de vue d'une même scène (9) par lesdites au moins deux caméras numériques indépendantes (3.1 - 3.4), dans lequel, après une prise de vue synchrone réussie, les quantités de lumière sont comparées entre elles, dans les domaines neutres de pixels (6b) correspondants du capteur d'image numérique de forme plane (6) desdites au moins deux caméras numériques indépendantes (3.1 -3.4), après quoi, lors du traitement d'une image synchronisée saisie de la même scène (9), par lesdites au moins deux caméras numériques indépendantes (3.1 - 3.4) dans les domaines spectraux différents respectifs à bande étroite (R, G, B, NIR), on effectue un calcul de compensation de telle manière que les signaux d'images dans les domaines spectraux différents respectifs à bande étroite (R, G, B, NIR), sont soit gardés inchangés, soit amortis, soit renforcés en fonction des variations détectées précédemment.

9. Unité de traitement d'image (4) d'un système à caméra numérique (2) agencée pour effectuer un procédé selon la revendication 8.
